# EUROPEAN PATENT APPLICATION

(11) **EP 4 676 193 A1**
(43) Date of publication of application: **07.01.2026**
(21) Application number: 25720618.5
(22) Date of filing: 10.04.2025
(51) Int. Cl.: H10F 77/20

(54) **SOLAR CELL AND PHOTOVOLTAIC MODULE**

(30) Priority: 15.05.2024 CN 202421065934 U; 26.09.2024 CN 202411358089
(71) Applicant: Longi Green Energy Technology Co., Ltd., Xi'an, Shaanxi 710100 (CN)
(72) Inventor: YAO, Weiran, Xi'an, Shaanxi 710100 (CN); YU, Long, Xi'an, Shaanxi 710100 (CN); XU, Xinxing, Xi'an, Shaanxi 710100 (CN); ZHANG, Zelin, Xi'an, Shaanxi 710100 (CN); ZHANG, Huan, Xi'an, Shaanxi 710100 (CN); LIU, Yikun, Xi'an, Shaanxi 710100 (CN); YANG, Xiaoming, Xi'an, Shaanxi 710100 (CN); TONG, Hongbo, Xi'an, Shaanxi 710100 (CN); FAN, Yunhao, Xi'an, Shaanxi 710100 (CN); ZHAO, Xueliang, Xi'an, Shaanxi 710100 (CN); CHEN, Yao, Xi'an, Shaanxi 710100 (CN)
(74) Representative: Grünecker Patent- und Rechtsanwälte PartG mbB
(86) International application number: PCT/CN2025/088321
(87) International publication number: WO 2025/236946

(57) **Abstract**

The present application discloses a solar cell and a photovoltaic module, and belongs to the field of photovoltaic technologies. The solar cell includes a cell body, where a width of the cell body is L₁ along a first direction; and a patterned region. The patterned region is arranged on a surface of the cell body, the patterned region has a plurality of fingers extending along a second direction, the plurality of fingers comprise a plurality of first fingers and a plurality of second fingers spaced from the first finger along the first direction, and the second direction being different from the first direction. The cell body has a first side and a second side arranged opposite to the first side, each of the first side and the second side including portions extending along the second direction, a distance between the first side and a position of the patterned region close to the first side being D₁. When the plurality of first fingers and the plurality of second fingers have opposite polarities, 80≤L₁/D₁≤400; and/or when the plurality of first fingers and the plurality of second fingers have a same polarity, 50≤L₁/D₁≤350.

## Description

### CROSS-REFERENCE TO RELATED APPLICATION

The present application claims priority to Chinese Patent Application No. 202421065934.9, filed with the China National Intellectual Property Administration on May 15, 2024 and entitled "SOLAR CELL AND PHOTOVOLTAIC MODULE" and Chinese Patent Application No. 202411358089.9, filed with the China National Intellectual Property Administration on September 26, 2024 and entitled "SOLAR CELL AND PHOTOVOLTAIC MODULE", each of which is incorporated herein by reference in its entirety.

### TECHNICAL FIELD

The present application relates to the field of photovoltaic technologies, and specifically, to a solar cell and a photovoltaic module.

### BACKGROUND

A solar cell is a core component of a photovoltaic module, and can convert solar energy into electric energy. A plurality of fingers are arranged on a surface of the solar cell, and the plurality of fingers are spaced from each other along a first direction and extend along a second direction, so that the plurality of fingers collect currents generated by the solar cell.

A region in which the plurality of fingers are located is an electrode patterned region. When sizes of solar cells are different, types of solar cells are different, and processes of solar cells are different, how to set distances between electrode patterned regions and edges of solar cells to improve the photoelectric conversion efficiency of the solar cells and a yield rate of the solar cells is not studied in the related art.

### SUMMARY

The present application discloses a solar cell and a photovoltaic module, to resolve or at least partially resolve the related-art technical problem of how to set a distance between an electrode patterned region and an edge of a solar cell to improve the photoelectric conversion efficiency of the solar cell and a yield rate of the solar cell.

To resolve the foregoing technical problem, the present application is implemented as follows:

According to a first aspect, the present application discloses a solar cell. The solar cell includes a cell body, where a width of the cell body is L1 along a first direction, a patterned region being defined on a surface of the cell body; and a plurality of fingers extending along a second direction, the plurality of fingers being arranged in the patterned region, where the plurality of fingers comprise a first finger and a second finger spaced from the first finger along the first direction, and the second direction being different from the first direction. The cell body has a first side and a second side arranged opposite to the first side, each of the first side and the second side including portions extending along the second direction, a distance between the first side and a position of the patterned region close to the first side being D1. When the first finger and the second finger have opposite polarities, 80≤L1/D1≤400; and/or when the first finger and the second finger have a same polarity, 50≤L1/D1≤350.

In an embodiment, the cell body includes a substrate and a doped semiconductor layer formed on the substrate, the plurality of fingers being in electrical contact with the doped semiconductor layer, the first side and the second side being sides of the substrate, a distance between the first side and a boundary of the doped semiconductor layer close to the first side being d1; when the first finger and the second finger have opposite polarities, L1/d1≥156; and/or when the first finger and the second finger have a same polarity, L1/d1≥131.

In an embodiment, when a plurality of first fingers and a plurality of second fingers have opposite polarities, a quantity of the plurality of first fingers or the plurality of second fingers is M, 0.9≤M/L1≤1.8; and/or when the plurality of first fingers and the plurality of second fingers have a same polarity, a sum of a quantity of the plurality of first fingers and a quantity of the plurality of second fingers is M, 0.9≤M/L1≤1.8.

In an embodiment, when the plurality of first fingers and the plurality of second fingers have opposite polarities, 0.93≤M/L1≤1.5; and/or when the plurality of first fingers and the plurality of second fingers have a same polarity, 0.93≤M/L1≤1.5.

In an embodiment, the cell body further includes two chamfers, and two ends of the first side are directly connected to the two chamfers, respectively. A distance between the second side and a position of the patterned region close to the second side along the first direction is D3, 0.5≤D3:D1≤1.

In an embodiment, when the plurality of first fingers and the plurality of second fingers have opposite polarities, a distance between a respective first finger of the plurality of first fingers and a second finger adjacent to the respective first finger along the first direction is N, 11.00≤L1/(D1+N)≤37.02, and/or N≤D1≤2N.

In an embodiment, along the first direction, a distance between two adjacent first fingers closest to an edge or two adjacent second fingers closest to an edge is N1, and a distance between two adjacent first fingers in the middle of the solar cell or second fingers in the middle of the solar cell is N2, D1<N1<N2, and/or 2D1>N1, or 2D1>N2, or 2N1>N2.

In an embodiment, a length of the cell body along the second direction is L2, and a distance between a position of the patterned region close to an edge of the cell body and the edge of the cell body is D2. When the plurality of first fingers and the plurality of second fingers have opposite polarities, 150≤L2/D2≤750; and/or when the plurality of first fingers and the plurality of second fingers have a same polarity, 50≤L2/D2≤650.

In an embodiment, a distance between a boundary of the doped semiconductor layer close to an edge of the cell body and the edge of the cell body along the second direction is d2; when the plurality of first fingers and the plurality of second fingers have opposite polarities, L2/d2≥312; and/or when the plurality of first fingers and the plurality of second fingers have a same polarity, L2/d2≥262.

In an embodiment, D1≥D2.

In an embodiment, in a case that the cell body is a rectangle structure or a rectangle-like structure, when the plurality of first fingers and the plurality of second fingers have opposite polarities, L1/D1≤L2/D2; and/or when the plurality of first fingers and the plurality of second fingers have a same polarity, L1/D1≥L2/D2.

In an embodiment, 75 mm≤L1≤175 mm; and/or a length of the cell body along the second direction is L2, 150 mm≤L2≤350 mm; and/or an area of the cell body is S, 11250 mm²≤S≤61250 mm².

In an embodiment, 50≤M≤225.

According to a second aspect, the present application discloses a solar cell. The solar cell includes a cell body, where a width of the cell body is L1 along a first direction, two patterned regions being defined on a surface of the cell body and spaced form each other along the first direction; and a plurality of fingers extending along a second direction, where the plurality of fingers comprise a first finger and a second finger spaced from the first finger along the first direction, and the second direction being different from the first direction. The cell body has a first side and a second side arranged opposite to the first side, each of the first side and the second side including portions extending along the second direction, a distance between the first side and a position of the patterned region close to the first side and a distance between the second side and a position of the patterned region close to the second side being both D1. When the first finger and the second finger have opposite polarities, 80≤L1/2D1≤400; and/or when the first finger and the second finger have a same polarity, 50≤L1/2D1≤350.

In an embodiment, when a plurality of first fingers and a plurality of second fingers have opposite polarities, a quantity of the plurality of first fingers or the plurality of second fingers is M, 0.9≤M/L1≤1.8; or when the plurality of first fingers and the plurality of second fingers have a same polarity, a sum of a quantity of the plurality of first fingers and a quantity of the plurality of second fingers is M, 0.9≤M/L1≤1.8.

In an embodiment, when the plurality of first fingers and the plurality of second fingers have opposite polarities, 0.93≤M/L1≤1.5; and/or when the plurality of first fingers and the plurality of second fingers have a same polarity, 0.93≤M/L1≤1.5.

In an embodiment, the cell body has four chamfers, two ends of the first side are directly connected to two of the four chamfers, respectively, and two ends of the second side are directly connected to the other two chamfers, respectively. A distance between the two patterned regions along the first direction is D3, 0.5≤D3:2D1≤1.

In an embodiment, when the plurality of first fingers and the plurality of second fingers have opposite polarities, a distance between a respective first finger of the plurality of first fingers and a second finger adjacent to the respective first finger along the first direction in a same patterned region is N, 11.00≤L1/2(D1+N)≤37.02, and/or N≤D1≤2N.

In an embodiment, in a same patterned region, along the first direction, a distance between two adjacent first fingers closest to an edge or two adjacent second fingers closest to an edge is N1, and a distance between two adjacent first fingers in the middle of the solar cell or second fingers in the middle of the solar cell is N2, D1<N1<N2, and/or 2D1>N1, or 2D1>N2, or 2N1>N2.

In an embodiment, a length of the cell body along the second direction is L2, and a distance between a position of the patterned region close to an edge of the cell body and the edge of the cell body is D2. When the plurality of first fingers and the plurality of second fingers have opposite polarities, 150≤L2/D2≤750; and/or when the plurality of first fingers and the plurality of second fingers have a same polarity, 50≤L2/D2≤650.

In an embodiment, D1≥D2.

In an embodiment, in a case that the cell body is a rectangle structure or a rectangle-like structure, when the plurality of first fingers and the plurality of second fingers have opposite polarities, L1/2D1≤L2/D2; and/or when the plurality of first fingers and the plurality of second fingers have a same polarity, L1/2D1≥L2/D2.

In an embodiment, 75 mm≤L1/2≤175 mm, and/or a length of the cell body along the second direction is L2, 150 mm≤L2≤350 mm; and/or an area of the cell body is S, 11250 mm²≤S/2≤61250 mm².

In an embodiment, 50≤M/2≤225.

According to a third aspect, the present application further discloses a photovoltaic module. The photovoltaic module includes a plurality of solar cells according to the first aspect, where the plurality of solar cells are spaced from each other.

The present application discloses a solar cell and a photovoltaic module. The solar cell includes a cell body and a patterned region arranged on a surface of the cell body. A width of the cell body is L1 along a first direction. The patterned region has a plurality of fingers extending along a second direction. The plurality of fingers includes a first finger and a second finger, and the first finger and the second finger are spaced from each other along the first direction. The cell body has a first side and a second side arranged opposite to the first side, each of the first side and the second side including portions extending along the second direction, a distance between the first side and a position of the patterned region close to the first side being D1. When the first finger and the second finger have opposite polarities, 80≤L1/D1≤400; and/or when the first finger and the second finger have a same polarity, 50≤L1/D1≤350.

In the present application, when the first finger and the second finger have opposite polarities, L1/D1 is set to be greater than or equal to 80 and less than or equal to 400; and/or when the first finger and the second finger have a same polarity, L1/D1 is set to be greater than or equal to 50 and less than or equal to 350. With the above arrangements, the ratio of L1/D1 can satisfy size requirements on D1 for solar cells having different widths L1, which reduces alignment difficulty in a forming process of the plurality of fingers and improves a yield rate of the plurality of fingers. Further, with the above arrangements, finger overlapping risk can be reduced and blocking loss can be reduced, so as to improve the photoelectric conversion efficiency of the solar cell.

### BRIEF DESCRIPTION OF THE DRAWINGS

FIG. 1 is a first schematic structural diagram of a solar cell according to an embodiment of the present application;
FIG. 2 is a second schematic structural diagram of a solar cell according to an embodiment of the present application;
FIG. 3 is a schematic partial structural diagram of a solar cell according to an embodiment of the present application;
FIG. 4 is a schematic structural diagram of a busbar of a solar cell in the related art;
FIG. 5 is a schematic structural diagram of a interconnecting part of a solar cell in the related art;
FIG. 6 is a side view of stress distribution of a interconnector in the related art;
FIG. 7 is a schematic structural diagram of a busbar of a solar cell according to an embodiment of the present application;
FIG. 8 is a schematic structural diagram of a interconnecting part of a solar cell according to an embodiment of the present application;
FIG. 9 is a side view of stress distribution of a interconnector according to an embodiment of the present application;
FIG. 10 is a third schematic structural diagram of a solar cell according to an embodiment of the present application; and
FIG. 11 is a fourth schematic structural diagram of a solar cell according to an embodiment of the present application.

### Descriptions of reference numerals:

10: Cell body; 100: Substrate; 101: Doped semiconductor layer; 11: First side; 12: Second side;
20: Patterned region;
30: Busbar; 31: Interconnecting part; 32: Connection line;
40: Interconnector;
A: First direction; and B: Second direction.

### DETAILED DESCRIPTION

The following clearly and completely describes the technical solutions in the embodiments of the present application with reference to the accompanying drawings in the embodiments of the present application. Apparently, the described embodiments are some but not all of the embodiments of the present application. All other embodiments obtained by persons of ordinary skill in the art based on the embodiments of the present application without creative efforts shall fall within the protection scope of the present application.

It should be understood that "one embodiment" or "an embodiment" mentioned in the specification means that specific features, structures, or characteristics related to the embodiment are included in at least one embodiment of the present application. Thus, appearances of "in one embodiment" or "in an embodiment" in various places throughout the specification are not necessarily referring to the same embodiment. In addition, these specific features, structures, or characteristics may be combined in one or more embodiments in any suitable manner.

Along a first direction, the solar cell has a first side and a second side arranged opposite to the first side. Along the first direction, if a width of the solar cell increases, a transmission resistance increases, and fingers need to be arranged densely. At the same time, a distance between an electrode patterned region and the first side of the solar cell needs to be adjusted. If the width of the solar cell decreases and light shielding increases, fingers need to be arranged sparsely, and the distance between the electrode patterned region and the first side of the solar cell also needs to be adjusted.

If the distance between the electrode patterned region and the first side of the solar cell along the first direction is excessively short, offset tolerance of the finger is reduced, alignment difficulty in a forming process of the finger is increased, and a yield rate of the finger is decreased. If the distance between the electrode patterned region and the first side of the solar cell along the first direction is excessively long, a distance between adjacent fingers decreases, and finger overlapping risk is high and blocking loss increases, affecting the photoelectric conversion efficiency of the solar cell.

For a back-contact solar cell, a positive-electrode finger and a negative-electrode finger are both arranged on a same surface of the solar cell, that is, are both arranged on a back surface of the solar cell. A distance between adjacent positive-electrode fingers or adjacent negative-electrode fingers is longer, and a carrier transport distance is longer. If the width of the solar cell along the first direction increases, compared with a bifacial contact solar cell, carrier transport difficulty of the back-contact solar cell is higher.

In addition, a positive-electrode finger and a negative-electrode finger of the back-contact solar cell are both arranged on the back surface of the solar cell; and compared with a bifacial contact solar cell, light shielding loss is larger. That is, if the width of the solar cell along the first direction decreases, light shielding loss of the back-contact solar cell is worse.

Therefore, for a back-contact solar cell and a bifacial contact solar cell, after the width of the solar cell along the first direction changes, adjustment extents of the distance between the first side of the solar cell and the finger closest to the first side of the solar cell are also different. To overcome the foregoing worsened loss, the width of the back-contact solar cell is set to be slightly small, and a ratio of the width of the solar cell along the first direction to the distance between the first side of the solar cell and the finger closest to the first side of the solar cell is slightly large.

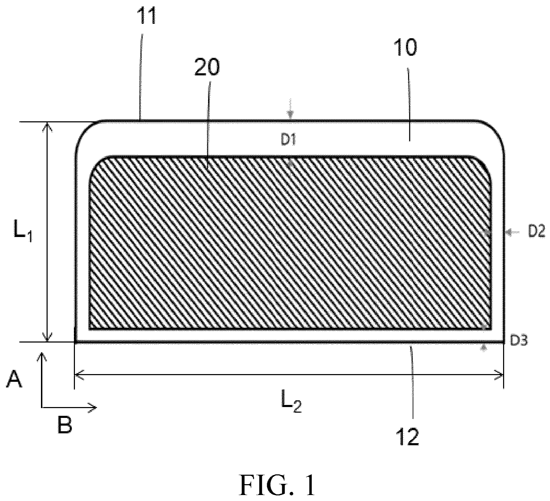

FIG. 1 is a first schematic structural diagram of a solar cell according to an embodiment of the present application.

As shown in FIG. 1, this embodiment of the present application discloses a solar cell. The solar cell includes a cell body 10, where a width of the cell body 10 is L1 along a first direction A; and a patterned region 20. The patterned region 20 is arranged on a surface of the cell body 10, the patterned region 20 has a plurality of fingers (not shown in the figure) extending along a second direction B, the finger includes a first finger (not shown in the figure) and a second finger (not shown in the figure), the first finger and the second finger are spaced from each other along the first direction A, and the second direction B is different from the first direction A. The cell body 10 has a first side 11 and a second side 12 arranged opposite to the first side, the first side 11 and the second side 12 include portions that extend along the second direction B, and a distance between the first side 11 and a position of the patterned region 20 close to the first side 11 is D1. When the plurality of first fingers and the plurality of second fingers have opposite polarities, 50≤L1/D1≤400; and/or when the plurality of first fingers and the plurality of second fingers have a same polarity, 50≤L1/D1≤350.

This embodiment of the present application discloses a solar cell. The solar cell is a core component of a photovoltaic module, and can convert solar energy into electric energy. The solar cell has a light receiving surface facing the sunlight, and the surface is also referred to as a front surface. The solar cell also has a backlight surface opposite to the sunlight, and the surface is also referred to as a back surface.

As shown in FIG. 1, the solar cell disclosed in the present application includes the cell body 10 and the patterned region 20 arranged on the surface of the cell body 10. The patterned region 20 may be arranged on the front surface of the cell body 10, or may be arranged on the back surface of the cell body 10. This is not specifically limited in this embodiment of the present application. In an actual application, persons skilled in the art may perform setting according to a requirement.

The cell body 10 may be a rectangle structure, a square structure, or a rectangle-like structure. The rectangle-like structure means that the solar cell of the rectangle-like structure has a round chamfer or a square chamfer, and the round chamfer or the square chamfer is directly connected to the first side 11 of the cell body 10. Certainly, the cell body 10 may also have another shape. In this embodiment of the present application, a specific structure of the cell body 10 is not excessively limited.

A related description is provided below by using an example in which the cell body 10 is a rectangle structure. When the cell body 10 is a rectangle structure, a width of the cell body 10 along the first direction A is L1, and a length of the cell body 10 along the second direction B is L2.

It should be noted that, as shown in FIG. 1, the solar cell in this embodiment of the present application is a half solar cell. It may be understood that, the half solar cell may be obtained by cutting an entire solar cell before a finger is formed, or may be obtained by cutting an entire solar cell after a finger is formed, or may be a half solar cell directly prepared from a half silicon wafer obtained by cutting an entire silicon wafer.

As shown in FIG. 1, the patterned region 20 is arranged on the surface of the cell body 10. The patterned region 20 has a plurality of fingers extending along the second direction B. The finger is also referred to as a finger. A region occupied by the plurality of fingers on the surface of the cell body 10 is referred to as the patterned region 20.

It should be noted that, the patterned region 20 may be a rectangle structure, a rectangle-like structure, a square structure, or a structure of another shape. In this embodiment of the present application, a specific shape of the patterned region 20 is not excessively limited either. In an actual application, persons skilled in the art may set a specific structure of the patterned region 20 according to a requirement.

A related description is provided below by using an example in which the patterned region 20 is a rectangle structure.

It should be noted that, in this embodiment of the present application, the finger includes a first finger and a second finger, and both the first finger and the second finger extend along the second direction B and are spaced from each other along the first direction A.

As shown in FIG. 1, when the cell body 10 is a rectangle structure, the cell body 10 has the first side 11 and the second side 12 arranged opposite to the first side, and the first side 11 and the second side 12 include portions that extend along the second direction B. The patterned region 20 is also a rectangle structure. A distance between the first side 11 and a position of the patterned region 20 close to the first side 11 is set to D1.

It should be noted that, in this embodiment of the present application, the position of the patterned region 20 close to the first side 11 is a position of a finger that is in the patterned region 20 and that is closest to the first side 11. That is, D1 is a distance between the first side 11 and a finger closest to the first side 11.

When the plurality of first fingers and the plurality of second fingers have opposite polarities, that is, when the solar cell is a back-contact solar cell, 80≤L1/D1≤400. In this embodiment of the present application, a ratio of the width L1 of the cell body 10 to the distance D1 between the first side 11 and the position of the patterned region 20 close to the first side 11 is set to be greater than or equal to 80 and less than or equal to 400. While both the carrier transport difficulty and electrode blocking loss are considered, electrode alignment difficulty and electrode overlapping risk are reduced, and the yield rate and the photoelectric conversion efficiency of the solar cell are improved.

For example, when the plurality of first fingers and the plurality of second fingers have opposite polarities, the ratio of the width L1 of the cell body 10 to the distance D1 between the first side 11 and the position of the patterned region 20 close to the first side 11 may be 80, 100, 125, 150, 175, 200, 225, 250, 300, 350, 380, 400, or the like. When the plurality of first fingers and the plurality of second fingers have a same polarity, that is, when the solar cell is a bifacial solar cell, 50≤L1/D1≤350. In this embodiment of the present application, a ratio of the width L1 of the cell body 10 to the distance D1 between the first side 11 and the position of the patterned region 20 close to the first side 11 is set to be greater than or equal to 50 and less than or equal to 350. While both the carrier transport difficulty and electrode blocking loss are considered, electrode alignment difficulty and electrode overlapping risk are reduced, and the yield rate and the photoelectric conversion efficiency of the solar cell are improved.

For example, when the plurality of first fingers and the plurality of second fingers have a same polarity, the ratio of the width L1 of the cell body 10 to the distance D1 between the first side 11 and the position of the patterned region 20 close to the first side 11 may be 50, 60, 80, 100, 120, 140, 160, 180, 220, 250, 300, 350, or the like.

In an embodiment, when the plurality of first fingers and the plurality of second fingers have opposite polarities, a quantity of the plurality of first fingers or the plurality of second fingers is M, 0.9≤M/L1≤1.8; and/or when the plurality of first fingers and the plurality of second fingers have a same polarity, a sum of a quantity of the plurality of first fingers and a quantity of the plurality of second fingers is M, 0.9≤M/L1≤1.8.

When the plurality of first fingers and the plurality of second fingers have opposite polarities, two types of electrodes of opposite polarities are arranged on the surface of the solar cell. The solar cell is a back-contact solar cell. The quantity of first fingers is M, or the quantity of second fingers is M, and 0.9≤M/L1≤1.8.

In this embodiment of the present application, the ratio of the quantity M of first fingers or second fingers to the width L1 of the cell body 10 is set to be greater than or equal to 0.9 and less than or equal to 1.8, so that the surface of the cell body 10 has sufficient fingers, thereby ensuring the current collection efficiency of the solar cell and improving the photoelectric conversion efficiency of the solar cell.

For example, when the plurality of first fingers and the plurality of second fingers have opposite polarities, the width of the cell body 10 along the first direction A is L1, the quantity of first fingers is M, and M/L1=0.9. Alternatively, M/L1=1.2. When the plurality of first fingers and the plurality of second fingers have opposite polarities, the width of the cell body 10 along the first direction A is L1, the quantity of second fingers is M, and M/L1=1.5. Alternatively, M/L1=1.8.

It should be noted that, when the plurality of first fingers and the plurality of second fingers have opposite polarities, that is, when the solar cell is a back-contact solar cell, if the quantity of first fingers and the quantity of second fingers are not the same, a value of M is the larger value of the quantity of first fingers and the quantity of second fingers.

When the plurality of first fingers and the plurality of second fingers have a same polarity, that is, electrodes of only one polarity are arranged on the surface of the solar cell, the solar cell is a bifacial solar cell. A sum of the quantity of first fingers and the quantity of second fingers is M, and 0.9≤M/L1≤1.8.

In this embodiment of the present application, the ratio of the sum M of the quantity of first fingers and the quantity of second fingers to the width L1 of the cell body 10 is set to be greater than or equal to 0.9 and less than or equal to 1.8, so that the surface of the cell body 10 has sufficient fingers, thereby ensuring the current collection efficiency of the solar cell and improving the photoelectric conversion efficiency of the solar cell.

For example, when the plurality of first fingers and the plurality of second fingers have a same polarity, the width of the cell body 10 along the first direction A is L1, the sum of the quantity of first fingers and the quantity of second fingers is M, and M/L1=0.9. Alternatively, M/L1=1.25. Alternatively, M/L1=1.5. Alternatively, M/L1=1.8.

In an embodiment, when the plurality of first fingers and the plurality of second fingers have opposite polarities, 0.93≤M/L1≤1.5; or when the plurality of first fingers and the plurality of second fingers have a same polarity, 0.93≤M/L1≤1.5. In this way, the surface of the cell body 10 has sufficient fingers, thereby ensuring the current collection efficiency of the solar cell and improving the photoelectric conversion efficiency of the solar cell.

In an embodiment, as shown in FIG. 1, the cell body 10 includes a chamfer, and two ends of the first side 11 are directly connected to the chamfer. A distance between the second side 12 and a position of the patterned region 20 close to the second side 12 along the first direction A is D3, 0.5≤D3:D1≤1.

As shown in FIG. 1, in this embodiment of the present application, the distance between the second side 12 and the position of the patterned region 20 close to the second side 12 along the first direction A is set to D3, 0.5≤D3:D1≤1. In the foregoing setting, an area of the patterned region 20 can be increased, and the position of the patterned region 20 can be determined, so that the surface region of the cell body 10 is maximally used, and the photoelectric conversion efficiency of the solar cell is improved.

Further, after a solar cell is formed in the region of the cell body 10 close to the second side 12, there may be partial cutting damage due to cutting. Therefore, D3:D1 is set to be less than or equal to 1. However, D3 should not be excessively small. If D3 is excessively small, a carrier collection area is affected. Therefore, in an embodiment of the present application, D3:D1 is set to be greater than or equal to 0.5.

Exemplarily, D3:D1=0.5. Alternatively, D3:D1=0.7. Alternatively, D3:D1=0.9. Alternatively, D3:D1=1.

It should be noted that, in this embodiment of the present application, the position of the patterned region 20 close to the second side 12 is a position of a finger that is in the patterned region 20 and that is closest to the second side 12. That is, D3 is a distance between the second side 12 and a finger closest to the second side 12.

In an embodiment, when the plurality of first fingers and the plurality of second fingers have opposite polarities, a distance between the first finger and the second finger adjacent to each other along the first direction A is N, 11.00≤L1/(D1+N)≤37.02, and/or N≤D1≤2N.

When the plurality of first fingers and the plurality of second fingers have opposite polarities, that is, when the solar cell is a back-contact solar cell, the back surface of the cell body 10 has a plurality of first fingers and a plurality of second fingers. The plurality of first fingers and the plurality of second fingers all extend along the second direction B, and are alternately arranged on the back surface of the cell body 10 along the first direction A. The distance between the first finger and the second finger adjacent to each other along the first direction A is N, and 11.00≤L1/(D1+N)≤37.02.

In the foregoing setting, the probability of successful alignment of the electrode pattern of the back-contact solar cell can be improved, the transmission resistance can be decreased, and the photoelectric conversion efficiency of the solar cell can be improved.

For example, L1/(D1+N)=11.00. Alternatively, L1/(D1+N)=15. Alternatively, L1/(D1+N)=20. Alternatively, L1/(D1+N)=25. Alternatively, L1/(D1+N)=30. Alternatively, L1/(D1+N)=35, and so on.

In this embodiment of the present application, a distance between the first finger and the second finger adjacent to each other is set to N, a distance between the first side 11 and a position of the patterned region 20 close to the first side 11 is set to D1, and N≤D1≤2N. In the foregoing setting, it can be ensured that carriers in the edge of the solar cell can be fully collected, so as to improve the photoelectric conversion efficiency of the solar cell.

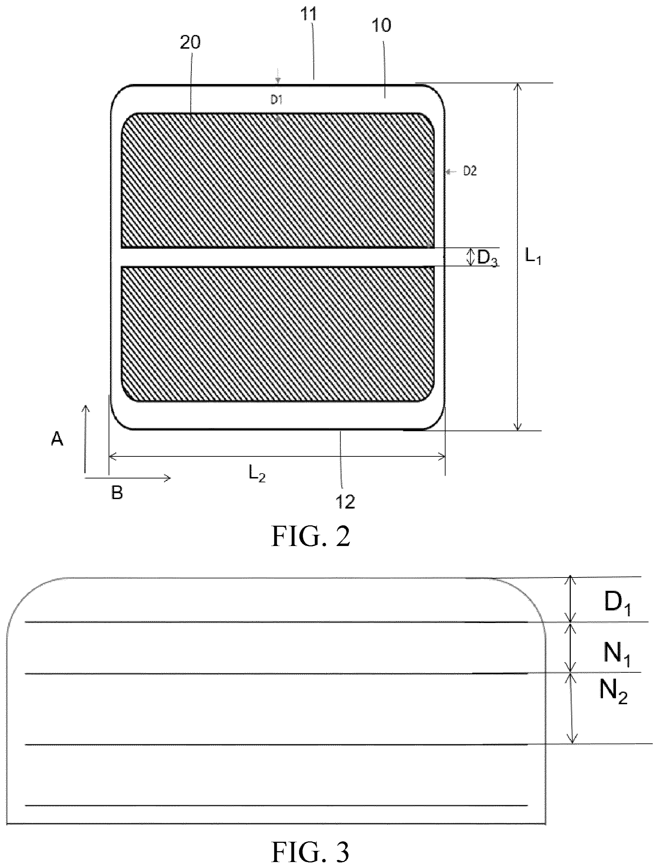

In an embodiment, as shown in FIG. 3, along the first direction A, a distance between two adjacent first fingers closest to an edge or two adjacent second fingers closest to an edge is N1, and a distance between two adjacent first fingers in the middle of the solar cell or second fingers in the middle of the solar cell is N2, D1<N1<N2, and/or 2D1>N1, or 2D1>N2, or 2N1>N2.

When arranging the first finger and the second finger, as described in the foregoing embodiment, distances between two adjacent fingers along the first direction A may be set to be the same. Alternatively, as described in this embodiment of the present application, distances between two adjacent fingers along the first direction A may be set to be not completely the same, and specific positions in which distances are not the same may be selected according to an actual requirement. Exemplarily, distances between two adjacent fingers located in the middle are the same, facilitating uniform carrier collection. A distance between two adjacent fingers located in an edge increases or decreases, so as to provide a sufficient space for the distance D1 between the first side 11 and the position of the patterned region 20 close to the first side 11.

It should be noted that, the solar cell in this embodiment of the present application may be a back-contact solar cell, or may be a bifacial contact solar cell. When the design of fingers between which distances are not the same is applicable to a back-contact solar cell, alternatively, distances between any two of three positive-electrode and negative-electrode fingers located in an edge increase or decrease, so as to provide a sufficient space for the distance D1 between the first side 11 and the position of the patterned region 20 close to the first side 11.

In an embodiment, as shown in FIG. 1, a length of the cell body 10 along the second direction B is L2, and a distance between a position of the patterned region 20 close to an edge of the cell body 10 and the edge of the cell body 10 is D2. When the plurality of first fingers and the plurality of second fingers have opposite polarities, 150≤L2/D2≤750; and/or when the plurality of first fingers and the plurality of second fingers have a same polarity, 50≤L2/D2≤650.

If the length L2 of the cell body 10 along the second direction B increases, the transmission resistance increases and the fingers are longer. Along the second direction B, the distance D2 between the position of the patterned region 20 close to the edge of the cell body 10 and the edge of the cell body 10 needs to be adjusted. If the length L2 of the cell body 10 along the second direction B decreases, light shielding increases and the fingers are shorter. Along the second direction B, the distance D2 between the position of the patterned region 20 close to the edge of the cell body 10 and the edge of the cell body 10 also needs to be adjusted.

However, along the second direction B, if the distance D2 between the position of the patterned region 20 close to the edge of the cell body 10 and the edge of the cell body 10 is excessively short, electrode offset tolerance is reduced, alignment difficulty is increased, and a yield rate of the finger is decreased. Along the second direction B, if the distance D2 between the position of the patterned region 20 close to the edge of the cell body 10 and the edge of the cell body 10 is excessively long, carriers cannot be fully collected, current loss is caused, and the photoelectric conversion efficiency of the solar cell is reduced.

By controlling the ratio L2/D2, a design requirement on D2 for solar cells of different sizes can be satisfied. While both the transport resistance and light shielding loss are considered, finger alignment difficulty and carrier collection loss are reduced, and the photoelectric conversion efficiency of the solar cell is improved.

For a back-contact solar cell, a positive-electrode finger and a negative-electrode finger are both arranged on a back surface of the solar cell. A distance between adjacent positive-electrode fingers or adjacent negative-electrode fingers is longer, and a carrier transport distance is longer. Compared with a bifacial contact solar cell, if L2 increases, carrier transport of the back-contact solar cell becomes more difficult.

Similarly, a positive-electrode finger and a negative-electrode finger of the back-contact solar cell are both arranged on the back surface of the solar cell, and light shielding loss is larger. Compared with a bifacial contact solar cell, if L2 decreases, light shielding loss of the back-contact solar cell is worsened.

Therefore, for the back-contact solar cell and the bifacial contact solar cell, after L2 changes, adjustment extents of D2 are different. To overcome the worsened loss, D2 is smaller and the ratio L2/D2 is slightly larger for the back-contact solar cell.

As shown in FIG. 1, when the cell body 10 is a rectangle structure, the length of the cell body 10 along the second direction B is L2. Along the second direction B, the distance between the position of the patterned region 20 close to the edge of the cell body 10 and the edge of the cell body 10 is set to D2.

It should be noted that, in this embodiment of the present application, the position of the patterned region 20 close to the edge of the cell body 10 along the second direction B is a position of an end of a finger close to the edge of the cell body 10 along the second direction B. D2 is a distance between the end close to the edge of the cell body 10 and the edge of the cell body 10 along the second direction B.

When the plurality of first fingers and the plurality of second fingers have opposite polarities, that is, when the solar cell is a back-contact solar cell, 150≤L2/D2≤750. In this embodiment of the present application, a ratio of the length L2 of the cell body 10 to the distance D2 between the position of the patterned region 20 close to the edge of the cell body 10 and the edge of the cell body 10 along the second direction B is set to be greater than or equal to 150 and less than or equal to 750. While both the transport resistance and light shielding loss are considered, finger alignment difficulty and carrier collection loss are reduced, and a yield rate and photoelectric conversion efficiency of the solar cell are improved.

For example, when the plurality of first fingers and the plurality of second fingers have opposite polarities, the ratio of the length L2 of the cell body 10 to the distance D2 between the position of the patterned region 20 close to the edge of the cell body 10 and the edge of the cell body 10 along the second direction B may be 150, 180, 200, 220, 240, 260, 280, 350, 400, 450, 500, 550, 600, 650, 700, 750, or the like.

When the plurality of first fingers and the plurality of second fingers have a same polarity, that is, when the solar cell is a bifacial solar cell, 50≤L2/D2≤650. In this embodiment of the present application, a ratio of the length L2 of the cell body 10 to the distance D2 between the position of the patterned region 20 close to the edge of the cell body 10 and the edge of the cell body 10 along the second direction B is set to be greater than or equal to 50 and less than or equal to 650. While both the transport resistance and light shielding loss are considered, finger alignment difficulty and carrier collection loss are reduced, and a yield rate and photoelectric conversion efficiency of the solar cell are improved.

For example, when the plurality of first fingers and the plurality of second fingers have a same polarity, the ratio of the length L2 of the cell body 10 to the distance D2 between the position of the patterned region 20 close to the edge of the cell body 10 and the edge of the cell body 10 along the second direction B may be 50, 70, 90, 110, 130, 150, 170, 200, 250, 300, 350, 400, 450, 500, 550, 600, 650, or the like.

The solar cell is a half solar cell, and the solar cell is a rectangle structure. In this case, for example, the width L1 of the solar cell along the first direction A is 105.1 mm, the length L2 of the solar cell along the second direction B is 182.3 mm, and a limit dimension is: L1/D1=350, and/or L2/D2=607. It should be noted that, in this embodiment of the present application, L1/D1 and L2/D2 may be independently applied, or may be simultaneously applied. The following is the same, and details are not described again.

The width L1 of the solar cell along the first direction A is 105.1 mm, the length L2 of the solar cell along the second direction B is 182.3 mm, and a size suitable for mass production is: L1/D1=263, and/or L2/D2=456.

Alternatively, the width L1 of the solar cell along the first direction A is 105.1 mm, the length L2 of the solar cell along the second direction B is 182.3 mm, and a ratio in response to slicing during or after solar cell preparation is: L1/D1=175, and/or L2/D2=304.

It should be noted that, a size tolerance of the solar cell in the foregoing embodiments is within ± 0. 25 mm. In this embodiment of the present application, a size tolerance of the solar cell is within ± 0. 25 mm.

In an embodiment, D1≥D2.

In this embodiment of the present application, the distance D1 between the first side 11 and the position of the patterned region 20 close to the first side 11 is set to be greater than or equal to the distance D2 between the position of the patterned region 20 close to an edge of the cell body 10 and the edge of the cell body 10 along the second direction B. That is, the distance D2 between the position of the patterned region 20 close to an edge of the cell body 10 and the edge of the cell body 10 along the second direction B is less than or equal to the distance D1 between the first side 11 and the position of the patterned region 20 close to the first side 11. In the foregoing setting, it can be ensured that an edge of the solar cell has a suitable current collection area, and the photoelectric conversion efficiency of the solar cell can be ensured.

In an embodiment, in a case that the cell body 10 is a rectangle structure or a rectangle-like structure, when the plurality of first fingers and the plurality of second fingers have opposite polarities, L1/D1≤L2/D2; and/or when the plurality of first fingers and the plurality of second fingers have a same polarity, L1/D1≥L2/D2.

In a case that the cell body 10 is a rectangle structure or a rectangle-like structure, when the plurality of first fingers and the plurality of second fingers have opposite polarities, that is, when the solar cell is a back-contact solar cell, L1/D1≤L2/D2. In a case that the cell body 10 is a rectangle structure or a rectangle-like structure, when the plurality of first fingers and the plurality of second fingers have a same polarity, that is, when the solar cell is a bifacial contact solar cell, L1/D1≥L2/D2.

It should be noted that, as shown in FIG. 1, the rectangle-like structure in this embodiment of the present application means that a chamfer is connected to two ends of the first side 11 of the cell body 10. The chamfer may be a circular chamfer, or may be a square chamfer. This is not specifically limited in this embodiment of the present application. In an actual application, persons skilled in the art may perform setting according to a requirement.

In an embodiment, 75 mm≤L1≤175 mm; and/or a length of the cell body 10 along the second direction B is L2, 150 mm≤L2≤350 mm; and/or an area of the cell body 10 is S, 11250 mm²≤S≤61250 mm².

As shown in FIG. 1, in this embodiment of the present application, the cell body 10 is a rectangle structure, a width of the cell body 10 along the first direction A is L1, and a length of the cell body 10 along the second direction B is L2.

75mm≤L1≤175mm. For example, L1=75mm. Alternatively, L1=80mm. Alternatively, L1=100mm. Alternatively, L1=125mm. Alternatively, L1=150mm. Alternatively, L1=175mm.

150mm≤L2≤350mm. For example, L2=150mm. Alternatively, L2=175mm. Alternatively, L2=200mm. Alternatively, L2=225mm. Alternatively, L2=250mm. Alternatively, L2=300mm. Alternatively, L2=350mm.

In this embodiment of the present application, the area of the cell body 10 is S. When the cell body 10 is a rectangle structure, the area S is a product of the width L1 of the cell body 10 and the length L2 of the cell body 10. 11250 mm²≤S≤61250 mm². Exemplarily, S=11250 mm². Alternatively, S=28125 mm². Alternatively, S=37500 mm². Alternatively, S=61250 mm².

In an embodiment, 50≤M≤225.

When the solar cell is a back-contact solar cell, a quantity of first fingers is M or a quantity of second fingers is M in the patterned region 20, and 50≤M≤225. In this way, the patterned region 20 has sufficient fingers, thereby ensuring the current collection efficiency of the solar cell and improving the photoelectric conversion efficiency of the solar cell.

Exemplarily, M=50. Alternatively, M=100. Alternatively, M=150. Alternatively, M=175. Alternatively, M=200. Alternatively, M=225.

When the solar cell is a bifacial solar cell, the sum of the quantity of first fingers and the quantity of second fingers in the patterned region 20 is M, and 50≤M≤225. In this way, the patterned region 20 has sufficient fingers, thereby ensuring the current collection efficiency of the solar cell and improving the photoelectric conversion efficiency of the solar cell.

Exemplarily, M=50. Alternatively, M=75. Alternatively, M=125. Alternatively, M=150. Alternatively, M=200. Alternatively, M=225.

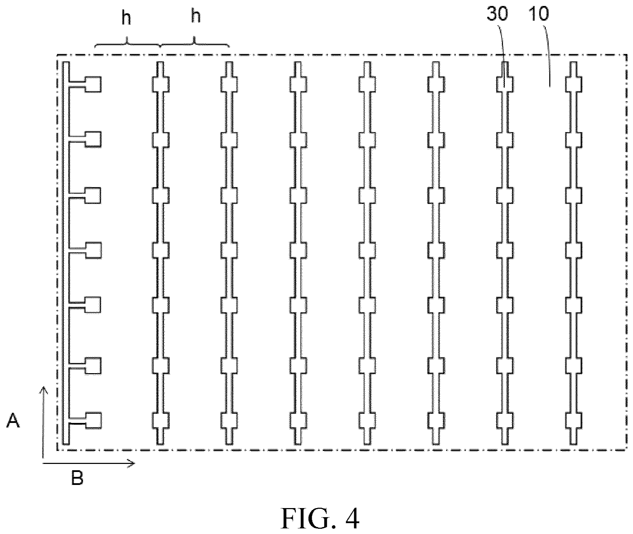

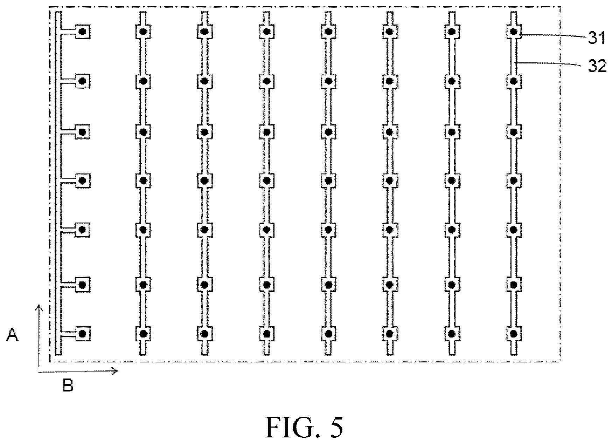

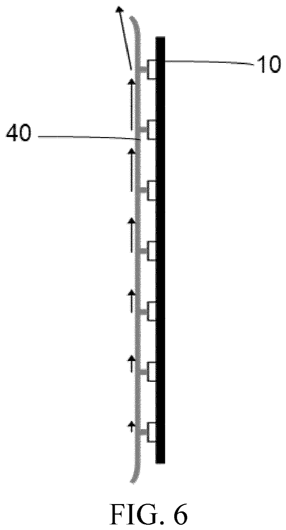

FIG. 4 is a schematic structural diagram of a busbar of a solar cell in the related art. FIG. 5 is a schematic structural diagram of a interconnecting part of a solar cell in the related art. FIG. 6 is a side view of stress distribution of a interconnector in the related art.

As shown in FIG. 4 to FIG. 6, in the related art, a plurality of busbars are arranged on the surface of the solar cell. The plurality of busbars all extend along the first direction A, and are spaced from each other along the second direction B. In addition, distances between two adjacent busbars along the second direction B are the same. However, in the related art, an arrangement manner of busbars leads to relatively low photoelectric conversion efficiency of a solar cell.

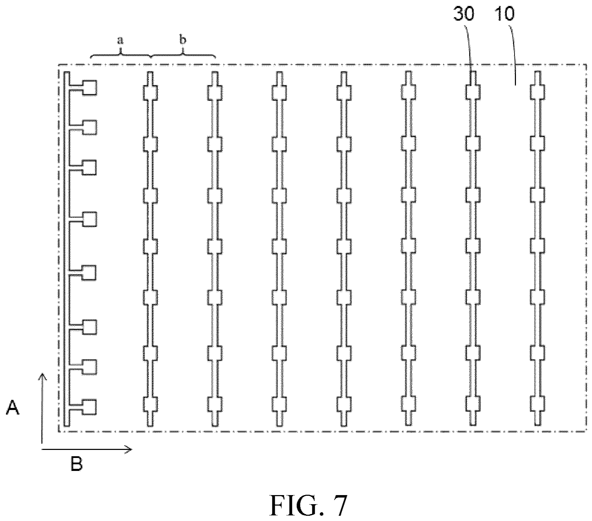

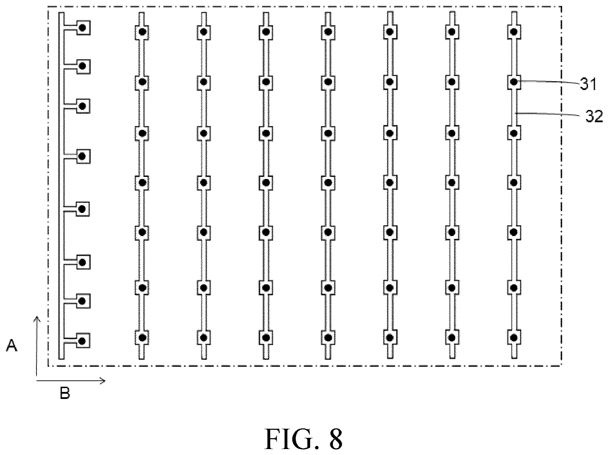

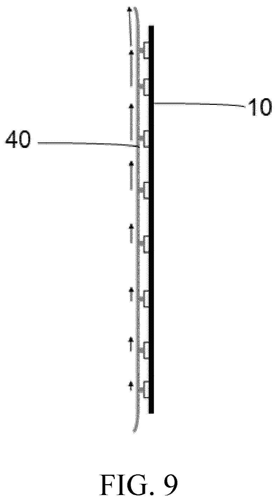

FIG. 7 is a schematic structural diagram of a busbar of a solar cell according to an embodiment of the present application. FIG. 8 is a schematic structural diagram of a interconnecting part of a solar cell according to an embodiment of the present application. FIG. 9 is a side view of stress distribution of a interconnector according to an embodiment of the present application.

As shown in FIG. 7 to FIG. 9, in the solar cell disclosed in the embodiments of the present application, a plurality of busbars 30 that extend along the first direction A and are spaced from each other along the second direction B are arranged on the surface of the cell body 10. Along the second direction B, there is a first distance a between two adjacent busbars 30 close to an edge of the cell body 10, and there is a second distance b between two adjacent busbars 30 relatively far from the edge of the cell body 10, where a>b, to improve carrier collection efficiency, reduce current mismatch, and avoid crack caused by edge soldering.

In this embodiment of the present application, the busbar 30 is connected to a finger, and the finger collects currents generated by the cell body 10. The busbar 30 combines and transmits the currents collected by the finger. The busbar 30 may be arranged on the front surface of the cell body 10, or may be arranged on the back surface of the cell body 10. This is not specifically limited in this embodiment of the present application. In an actual application, persons skilled in the art may perform setting according to a requirement.

It should be noted that, the busbar 30 is conductive.

As shown in FIG. 7 to FIG. 9, in this embodiment of the present application, along the second direction B, a distance between two adjacent busbars 30 close to an edge of the cell body 10 is set as the first distance a, and a distance between two adjacent busbars 30 relatively far from the edge of the cell body 10 is set as the second distance b. It may be understood that, along the second direction B, the first distance a is closer to a side of the cell body 10 relative to the second distance b. The first distance a is greater than the second distance b.

In this embodiment of the present application, along the second direction B, a distance between two adjacent busbars 30 close to an edge of the cell body 10 is set as the first distance a, a distance between two adjacent busbars 30 relatively far from the edge of the cell body 10 is set as the second distance b, and the first distance a is set to be greater than the second distance b, to improve carrier collection efficiency, reduce current mismatch, and avoid crack caused by edge soldering.

In an embodiment, 0<a - b≤5 mm, and/or 15 mm≤a≤25 mm and 15 mm≤b≤25 mm.

In this embodiment of the present application, along the second direction B, a difference between the first distance a between two adjacent busbars 30 relatively close to an edge of the cell body 10 and the second distance b between two adjacent busbars 30 relatively far from the edge of the cell body 10 is set to be greater than 0 mm and less than or equal to 5 mm, to balance current collection and improve the photoelectric conversion efficiency of the solar cell.

For example, the difference between the first distance a and the second distance b may be set to 1 mm, 2 mm, 3 mm, 4 mm, or the like.

It should be noted that, in this embodiment of the present application, specific lengths of the first distance a and the second distance b are not limited, as long as the second distance a is greater than the first distance b. In an actual application, persons skilled in the art may set specific values of the second distance b and the first distance a according to a requirement.

In this embodiment of the present application, along the second direction B, the first distance a between two adjacent busbars 30 close to an edge of the cell body 10 is set to be greater than or equal to 15 mm and less than or equal to 25 mm. For example, the first distance a may be 15 mm, 17 mm, 19 mm, 21 mm, 23 mm, 25 mm, or the like.

In this embodiment of the present application, along the second direction B, the second distance b between two adjacent busbars 30 relatively far from the edge of the cell body 10 is also set to be greater than or equal to 15 mm and less than or equal to 25 mm. For example, the second distance b may be 15 mm, 16 mm, 18 mm, 20 mm, 22 mm, 24 mm, 25 mm, or the like.

For example, when the first distance a is 20 mm, the second distance b may be 15 mm. When the first distance a is 22 mm, the second distance b may be 17 mm.

In an embodiment, as shown in FIG. 7 to FIG. 9, along the first direction A, the busbar 30 includes a interconnecting part 31 and a connection line 32. There are a plurality of interconnecting parts 31, the plurality of interconnecting parts 31 are spaced from each other, and the connection line 32 is electrically connected to the plurality of interconnecting parts 31.

As shown in FIG. 7 to FIG. 9, the busbar 30 in this embodiment of the present application includes a plurality of interconnecting parts 31, and the plurality of interconnecting parts 31 are spaced from each other along the first direction A. The connection line 32 is electrically connected to the plurality of interconnecting parts 31, to form the busbar 30. Currents generated by the cell body 10 are collected by the busbar 30.

It should be noted that, in this embodiment of the present application, the interconnector 40 is connected to the surface of the cell body 10 by using the interconnecting part 31, to collect and transmit the currents generated by the cell body 10. For example, the interconnector 40 may be soldered to the interconnecting part 31.

As shown in FIG. 2, an embodiment of the present application further discloses a solar cell. The solar cell includes two solar cells according to the foregoing embodiments. It may be understood that, the solar cell in the foregoing embodiments is a minimum cell unit, and the solar cell in this embodiment of the present application includes two solar cells in the minimum unit.

For example, the solar cell in the foregoing embodiments is a half solar cell. However, the solar cell in this embodiment of the present application includes two half solar cells. That is, the solar cell in this embodiment of the present application is an entire solar cell. In an embodiment, L1 corresponds to a short side of a half solar cell, and L2 corresponds to a long side of the half solar cell; or L1 corresponds to a long side of an entire solar cell, and L2 corresponds to a short side of the entire solar cell.

As shown in FIG. 2, the solar cell in this embodiment of the present application further includes two patterned regions 20, and the two patterned regions 20 are spaced from each other in a solar cell along the first direction A.

It may be understood that, in the solar cell disclosed in this embodiment of the present application, the width of the cell body along the first direction A is L1, and the length of the cell body along the second direction B is L2. A quantity of first fingers and/or second fingers in the two patterned regions 20 is M.

It should be noted that, specific parameters of the solar cell in this embodiment of the present application are not described herein again, and the specific parameters of the solar cell in this embodiment of the present application are set with reference to the foregoing embodiments.

In addition, a structure of the solar cell included in the solar cell disclosed in this embodiment of the present application is the same as that of the solar cell disclosed in the foregoing embodiments, and beneficial effects thereof are also similar. Details are not described herein again.

In an embodiment, as shown in FIG. 2, when the plurality of first fingers and the plurality of second fingers have opposite polarities, a quantity of the plurality of first fingers or the plurality of second fingers is M, 0.9≤M/L1≤1.8; and/or when the plurality of first fingers and the plurality of second fingers have a same polarity, a sum of a quantity of the plurality of first fingers and a quantity of the plurality of second fingers is M, 0.9≤M/L1≤1.8.

When the plurality of first fingers and the plurality of second fingers have opposite polarities, two types of electrodes of opposite polarities are arranged on the surface of the solar cell. The solar cell is a back-contact solar cell. The quantity of first fingers is M, or the quantity of second fingers is M, and 0.9≤M/L1≤1.8.

In this embodiment of the present application, the ratio of the quantity M of first fingers or second fingers to the width L1 of the cell body 10 is set to be greater than or equal to 0.9 and less than or equal to 1.8, so that the surface of the cell body 10 has sufficient fingers, thereby ensuring the current collection efficiency of the solar cell and improving the photoelectric conversion efficiency of the solar cell.

For example, when the plurality of first fingers and the plurality of second fingers have opposite polarities, the width of the cell body 10 along the first direction A is L1, the quantity of first fingers is M, and M/L1=0.9. Alternatively, M/L1=1.2. When the plurality of first fingers and the plurality of second fingers have opposite polarities, the width of the cell body 10 along the first direction A is L1, the quantity of second fingers is M, and M/L1=1.5. Alternatively, M/L1=1.8.

It should be noted that, when the plurality of first fingers and the plurality of second fingers have opposite polarities, that is, when the solar cell is a back-contact solar cell, if the quantity of first fingers and the quantity of second fingers are not the same, a value of M is the larger value of the quantity of first fingers and the quantity of second fingers.

When the plurality of first fingers and the plurality of second fingers have a same polarity, that is, electrodes of only one polarity are arranged on the surface of the solar cell, the solar cell is a bifacial solar cell. A sum of the quantity of first fingers and the quantity of second fingers is M, and 0.9≤M/L1≤1.8.

In this embodiment of the present application, the ratio of the sum M of the quantity of first fingers and the quantity of second fingers to the width L1 of the cell body 10 is set to be greater than or equal to 0.9 and less than or equal to 1.8, so that the surface of the cell body 10 has sufficient fingers, thereby ensuring the current collection efficiency of the solar cell and improving the photoelectric conversion efficiency of the solar cell.

For example, when the plurality of first fingers and the plurality of second fingers have a same polarity, the width of the cell body 10 along the first direction A is L1, the sum of the quantity of first fingers and the quantity of second fingers is M, and M/L1=0.9. Alternatively, M/L1=1.25. Alternatively, M/L1=1.5. Alternatively, M/L1=1.8.

In an embodiment, when the plurality of first fingers and the plurality of second fingers have opposite polarities, 0.93≤M/L1≤1.5; or when the plurality of first fingers and the plurality of second fingers have a same polarity, 0.93≤M/L1≤1.5. In this way, the surface of the cell body 10 has sufficient fingers, thereby ensuring the current collection efficiency of the solar cell and improving the photoelectric conversion efficiency of the solar cell.

In an embodiment, as shown in FIG. 2, the cell body 10 includes a chamfer, two ends of the first side 11 are directly connected to the chamfer, and two ends of the second side 12 are directly connected to the chamfer. There are two patterned regions 20. The two patterned regions 20 are spaced from each other along the first direction A, a distance between the two patterned regions 20 is D3, 0.5≤D3:2D1≤1.

As shown in FIG. 2, in this embodiment of the present application, the distance between the two patterned regions 20 along the first direction A is set to D3, 0.5≤D3:2D1≤1. In the foregoing setting, an area of the patterned region 20 can be increased, and the position of the patterned region 20 can be determined, so that the surface region of the cell body 10 is maximally used, and the photoelectric conversion efficiency of the solar cell is improved.

Further, after a solar cell is formed in a portion between the two patterned regions 20, there may be partial cutting damage due to cutting. Therefore, D3:2D1 is set to be less than or equal to 1. However, D3 should not be excessively small. If D3 is excessively small, a carrier collection area is affected. Therefore, in an embodiment of the present application, D3:2D1 is set to be greater than or equal to 0.5.

Exemplarily, D3:2D1=0.5. Alternatively, D3:2D1=0.7. Alternatively, D3:2D1=0.9. Alternatively, D3:2D1=1.

It should be noted that, in this embodiment of the present application, a distance D3 between two patterned regions 20 is a distance between a finger that is in a patterned region 20 and that is closest to another patterned region 20 and a finger that is in the another patterned region 20 and that is closest to the patterned region 20.

In an embodiment, when the plurality of first fingers and the plurality of second fingers have opposite polarities, a distance between the first finger and the second finger adjacent to each other along the first direction A in a same patterned region is N, 11.00≤L1/(D1+N)≤37.02, and/or N≤D1≤2N.

When the plurality of first fingers and the plurality of second fingers have opposite polarities, that is, when the solar cell is a back-contact solar cell, the back surface of the cell body 10 has a plurality of first fingers and a plurality of second fingers. The plurality of first fingers and the plurality of second fingers all extend along the second direction B, and are alternately arranged on the back surface of the cell body 10 along the first direction A. The distance between the first finger and the second finger adjacent to each other along the first direction A is N, and 11.00≤L1/(D1+N)≤37.02.

In the foregoing setting, the probability of successful alignment of the electrode pattern of the back-contact solar cell can be improved, the transmission resistance can be decreased, and the photoelectric conversion efficiency of the solar cell can be improved.

For example, L1/(D1+N)=11.00. Alternatively, L1/(D1+N)=15. Alternatively, L1/(D1+N)=20. Alternatively, L1/(D1+N)=25. Alternatively, L1/(D1+N)=30. Alternatively, L1/(D1+N)=35, and so on.

In this embodiment of the present application, a distance between the first finger and the second finger adjacent to each other is set to N, a distance between the first side 11 and a position of the patterned region 20 close to the first side 11 is set to D1, and N≤D1≤2N. In the foregoing setting, it can be ensured that carriers in the edge of the solar cell can be fully collected, so as to improve the photoelectric conversion efficiency of the solar cell.

In an embodiment, as shown in FIG. 3, in a same patterned region 20, along the first direction A, a distance between two adjacent first fingers or second fingers closest to an edge is N1, a distance between two adjacent first fingers or second fingers located in the middle is N2, D1<N1<N2, and/or 2D1>N1, or 2D1>N2, or 2N1>N2.

When arranging the first finger and the second finger, as described in the foregoing embodiment, distances between two adjacent fingers along the first direction A may be set to be the same. Alternatively, as described in this embodiment of the present application, distances between two adjacent fingers along the first direction A may be set to be not completely the same, and specific positions between which distances are not the same may be selected according to an actual requirement.

Exemplarily, in a same patterned region 20, distances between two adjacent fingers located in the middle are the same, facilitating uniform carrier collection. A distance between two adjacent fingers located in an edge decreases, so as to provide a sufficient space for the distance D1 between the first side 11 and the position of the patterned region 20 close to the first side 11.

In an embodiment, as shown in FIG. 2, a length of the cell body 10 along the second direction B is L2, and a distance between a position of the patterned region 20 close to an edge of the cell body 10 and the edge of the cell body 10 is D2. When the plurality of first fingers and the plurality of second fingers have opposite polarities, 150≤L2/D2≤750; and/or when the plurality of first fingers and the plurality of second fingers have a same polarity, 50≤L2/D2≤650.

If the length L2 of the cell body 10 along the second direction B increases, the transmission resistance increases and the fingers are longer. Along the second direction B, the distance D2 between the position of the patterned region 20 close to the edge of the cell body 10 and the edge of the cell body 10.needs to be adjusted. If the length L2 of the cell body 10 along the second direction B decreases, light shielding increases and the fingers are shorter. Along the second direction B, the distance D2 between the position of the patterned region 20 close to the edge of the cell body 10 and the edge of the cell body 10 also needs to be adjusted.

However, along the second direction B, if the distance D2 between the position of the patterned region 20 close to the edge of the cell body 10 and the edge of the cell body 10 is excessively short, electrode offset tolerance is reduced, alignment difficulty is increased, and a yield rate of the finger is decreased. Along the second direction B, if the distance D2 between the position of the patterned region 20 close to the edge of the cell body 10 and the edge of the cell body 10 is excessively long, carriers cannot be fully collected, current loss is caused, and the photoelectric conversion efficiency of the solar cell is reduced.

By controlling the ratio L2/D2, a design requirement on D2 for solar cells of different sizes can be satisfied. While both the transport resistance and light shielding loss are considered, finger alignment difficulty and carrier collection loss are reduced, and the photoelectric conversion efficiency of the solar cell is improved.

For a back-contact solar cell, a positive-electrode finger and a negative-electrode finger are both arranged on a back surface of the solar cell. A distance between adjacent positive-electrode fingers or adjacent negative-electrode fingers is longer, and a carrier transport distance is longer. Compared with a bifacial contact solar cell, if L2 increases, carrier transport of the back-contact solar cell becomes more difficult.

Similarly, a positive-electrode finger and a negative-electrode finger of the back-contact solar cell are both arranged on the back surface of the solar cell, and light shielding loss is larger. Compared with a bifacial contact solar cell, if L2 decreases, light shielding loss of the back-contact solar cell is worsened.

Therefore, for the back-contact solar cell and the bifacial contact solar cell, after L2 changes, adjustment extents of D2 are different. To overcome the worsened loss, D2 is smaller and the ratio L2/D2 is slightly larger for the back-contact solar cell.

As shown in FIG. 2, when the cell body 10 is a rectangle structure, the length of the cell body 10 along the second direction B is L2. Along the second direction B, the distance between the position of the patterned region 20 close to the edge of the cell body 10 and the edge of the cell body 10 is set to D2.

It should be noted that, in this embodiment of the present application, the position of the patterned region 20 close to the edge of the cell body 10 along the second direction B is a position of an end of a finger close to the edge of the cell body 10 along the second direction B. D2 is a distance between the end close to the edge of the cell body 10 and the edge of the cell body 10 along the second direction B.

When the plurality of first fingers and the plurality of second fingers have opposite polarities, that is, when the solar cell is a back-contact solar cell, 150≤L2/D2≤750. In this embodiment of the present application, a ratio of the length L2 of the cell body 10 to the distance D2 between the position of the patterned region 20 close to the edge of the cell body 10 and the edge of the cell body 10 along the second direction B is set to be greater than or equal to 150 and less than or equal to 750. While both the carrier transport difficulty and electrode blocking loss are considered, electrode alignment difficulty and electrode overlapping risk are reduced, and the yield rate and the photoelectric conversion efficiency of the solar cell are improved.

For example, when the plurality of first fingers and the plurality of second fingers have opposite polarities, the ratio of the length L2 of the cell body 10 to the distance D2 between the position of the patterned region 20 close to the edge of the cell body 10 and the edge of the cell body 10 along the second direction B may be 150, 180, 200, 220, 240, 260, 280, 350, 400, 450, 500, 550, 600, 650, 700, 750, or the like.

When the plurality of first fingers and the plurality of second fingers have a same polarity, that is, when the solar cell is a bifacial solar cell, 50≤L2/D2≤650. In this embodiment of the present application, a ratio of the length L2 of the cell body 10 to the distance D2 between the position of the patterned region 20 close to the edge of the cell body 10 and the edge of the cell body 10 along the second direction B is set to be greater than or equal to 50 and less than or equal to 650. While both the carrier transport difficulty and electrode blocking loss are considered, electrode alignment difficulty and electrode overlapping risk are reduced, and the yield rate and the photoelectric conversion efficiency of the solar cell are improved.

For example, when the plurality of first fingers and the plurality of second fingers have a same polarity, the ratio of the length L2 of the cell body 10 to the distance D2 between the position of the patterned region 20 close to the edge of the cell body 10 and the edge of the cell body 10 along the second direction B may be 50, 70, 90, 110, 130, 150, 170, 200, 250, 300, 350, 400, 450, 500, 550, 600, 650, or the like.

The solar cell is an entire solar cell and the solar cell is a rectangle structure. In this case, for example, the width L1 of the solar cell along the first direction A is 210 mm, the length L2 of the solar cell along the second direction B is 182.2 mm, and a limit size is: L1/D1=210/2/0.3=350, and/or L2/D2=182.2/0.3=607. It should be noted that, in this embodiment of the present application, L1/D1 and L2/D2 may be independently applied, or may be simultaneously applied. The following is the same, and details are not described again.

The width L1 of the solar cell along the first direction A is 210 mm, the length L2 of the solar cell along the second direction B is 182.2 mm, and a size suitable for mass production is: L1/D1=210/2/0.4=263, and/or L2/D2=182.2/0.4=456.

Alternatively, the width L1 of the solar cell along the first direction A is 210 mm, the length L2 of the solar cell along the second direction B is 182.2 mm, and a ratio in response to slicing during or after solar cell preparation is: L1/D1=210/2/0.6=175, and/or L2/D2=182.2/0.6=304.

It should be noted that, a size tolerance of the solar cell in the foregoing embodiments is within ± 0. 25 mm. In this embodiment of the present application, a size tolerance of the solar cell is within ± 0. 25 mm.

In an embodiment, D1≥D2.

In this embodiment of the present application, the distance D1 between the first side 11 and the position of the patterned region 20 close to the first side 11 is set to be greater than or equal to the distance D2 between the position of the patterned region 20 close to an edge of the cell body 10 and the edge of the cell body 10 along the second direction B. That is, the distance D2 between the position of the patterned region 20 close to an edge of the cell body 10 and the edge of the cell body 10 along the second direction B is less than or equal to the distance D1 between the first side 11 and the position of the patterned region 20 close to the first side 11. In the foregoing setting, it can be ensured that an edge of the solar cell has a suitable current collection area, and the photoelectric conversion efficiency of the solar cell can be ensured.

In an embodiment, as shown in FIG. 2, in a case that the cell body 10 is a rectangle structure or a rectangle-like structure, when the plurality of first fingers and the plurality of second fingers have opposite polarities, L1/2D1≤L2/D2; and/or when the plurality of first fingers and the plurality of second fingers have a same polarity, L1/2D1≥L2/D2.

In a case that the cell body 10 is a rectangle structure or a rectangle-like structure, when the plurality of first fingers and the plurality of second fingers have opposite polarities, that is, when the solar cell is a back-contact solar cell, L1/2D1≤L2/D2. In a case that the cell body 10 is a rectangle structure or a rectangle-like structure, when the plurality of first fingers and the plurality of second fingers have a same polarity, that is, when the solar cell is a bifacial contact solar cell, L1/2D1≥L2/D2.

It should be noted that, as shown in FIG. 2, the rectangle-like structure in this embodiment of the present application means that a chamfer is connected to two ends of the first side 11 of the cell body 10, and a chamfer is connected to two ends of the second side 12 of the cell body 10. The chamfer may be a circular chamfer, or may be a square chamfer. This is not specifically limited in this embodiment of the present application. In an actual application, persons skilled in the art may perform setting according to a requirement.

In an embodiment, 75 mm≤L1/2≤175 mm; and/or a length of the cell body 10 along the second direction B is L2, 150 mm≤L2≤350 mm; and/or an area of the cell body 10 is S, 11250 mm²≤S/2≤61250 mm².

As shown in FIG. 2, in this embodiment of the present application, the cell body 10 is a rectangle structure, a width of the cell body 10 along the first direction A is L1, and a length of the cell body 10 along the second direction B is L2.

75mm≤L1/2≤175mm. For example, L1/2=75 mm. Alternatively, L1/2=80mm. Alternatively, L1/2=100mm. Alternatively, L1/2=125mm. Alternatively, L1/2=150mm. Alternatively, L1/2=175mm.

150mm≤L2≤350mm. For example, L2=150mm. Alternatively, L2=175mm. Alternatively, L2=200mm. Alternatively, L2=225mm. Alternatively, L2=250mm. Alternatively, L2=300mm. Alternatively, L2=350mm.

In this embodiment of the present application, the area of the cell body 10 is S. When the cell body 10 is a rectangle structure, the area S is a product of the width L1 of the cell body 10 and the length L2 of the cell body 10. 11250 mm²≤S/2≤61250 mm². For example, S/2=11250 mm². Alternatively, S/2=28125 mm². Alternatively, S/2=37500 mm². Alternatively, S/2=61250 mm².

In an embodiment, 50≤M/2≤225.

When the solar cell is a back-contact solar cell, a quantity of first fingers is M or a quantity of second fingers is M in the patterned region 20, and 50≤M/2≤225. In this way, the patterned region 20 has sufficient fingers, thereby ensuring the current collection efficiency of the solar cell and improving the photoelectric conversion efficiency of the solar cell.

It should be noted that, in this embodiment of the present application, the quantity M of fingers is a quantity of all fingers in the two patterned regions 20 on the entire solar cell. It may be understood that, the quantity of fingers in one patterned region 20 is M/2.

For example, M/2=50. Alternatively, M/2=100. Alternatively, M/2=150. Alternatively, M/2=175. Alternatively, M/2=200. Alternatively, M/2=225.

When the solar cell is a bifacial solar cell, the sum of the quantity of first fingers and the quantity of second fingers in the patterned region 20 is M, and 50≤M/2≤225. In this way, the patterned region 20 has sufficient fingers, thereby ensuring the current collection efficiency of the solar cell and improving the photoelectric conversion efficiency of the solar cell.

For example, M/2=50. Alternatively, M/2=75. Alternatively, M/2=125. Alternatively, M/2=150. Alternatively, M/2=200. Alternatively, M/2=225.

In another aspect, the cell body includes a substrate and a doped semiconductor layer formed on the substrate. For the back-contact solar cell, both a P-type doped semiconductor region and an N-type doped semiconductor region are located on a same surface of the solar cell, a distance between adjacent P-type doped semiconductor regions or N-type doped semiconductor regions is longer, and a carrier separation transport distance is longer. If the width of the solar cell along the first direction increases, compared with a bifacial contact solar cell, carrier transport difficulty of the back-contact solar cell is higher. Moreover, for the back-contact solar cell, both the P-type doped semiconductor region and the N-type doped semiconductor region are arranged on the back of the solar cell. Compared with a bifacial contact solar cell, a larger effective power generation area is lost. That is, if the width of the solar cell along the first direction decreases, the loss of the effective power generation area of the back-contact solar cell is more severe. In addition, an edge isolation requirement of the bifacial contact solar cell is higher than that of the back-contact solar cell. Therefore, for the back-contact solar cell and the bifacial contact solar cell, after the width of the solar cell along the first direction changes, adjustment extents of the distance between the first side and the boundary of the doped semiconductor layer near the first side are also different. To overcome the worsened loss and meet the edge isolation requirements of different types of solar cells, for the back-contact solar cell, a ratio of the width of the solar cell along the first direction to the distance between the first side and the boundary of the doped semiconductor layer near the first side is slightly larger.

Because a width of the doped semiconductor layer is usually greater than that of an electrode, the alignment accuracy requirement of the doped semiconductor layer is higher after the size of the solar cell changes. Furthermore, in addition to functionality, the doped semiconductor layer also needs to be designed to match the electrode. Generally, a finger is located in the middle of the doped semiconductor layer, but there may be a deviation to some extent in practice. If the deviation is excessively large, the electrode explodes beyond the region of the doped semiconductor layer, posing electricity leakage risk. Therefore, a specific distance needs to be maintained between the electrode and the doped semiconductor layer, such as at least 0.005mm.

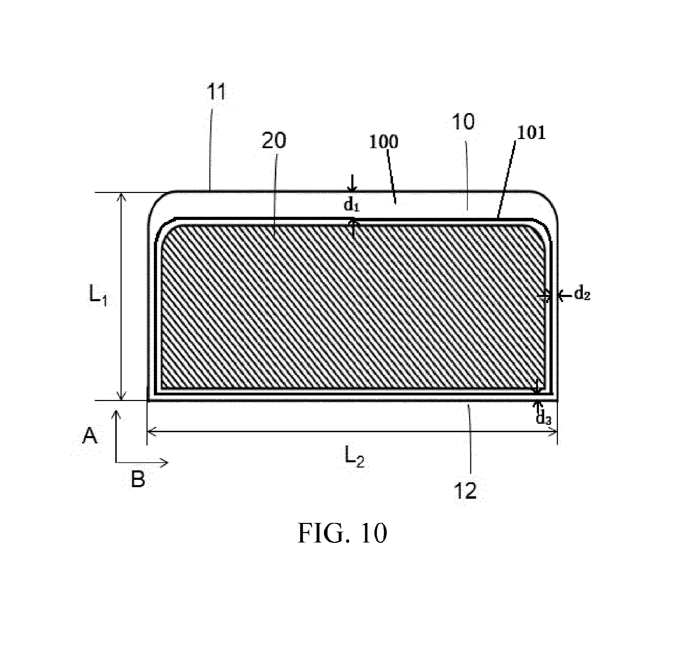

As shown in FIG 10, an embodiment of the present application discloses a solar cell, including: a cell body 10, the cell body including a substrate 100 and a doped semiconductor layer 101 formed on the substrate; and a patterned region 20, arranged on a surface of the cell body, where the patterned region has a plurality of fingers, the plurality of fingers being in electrical contact with the doped semiconductor layer, and the substrate has a first side 11 and a second side 12 that are oppositely arranged. A distance between the first side and a boundary of the doped semiconductor layer close to the first side is d1, a distance between a boundary of the doped semiconductor layer close to an edge of the cell body and the edge of the cell body along the second direction is d2, and a distance between the second side and a boundary of the doped semiconductor layer close to the second side is d3.

It can be understood that in the solar cell disclosed in this embodiment of the present application, a width of the cell body along the first direction A is L1, and a length of the cell body along the second direction B is L2. When the solar cell is a back-contact solar cell, L1/d1≥156 and L2/d2≥312; when the solar cell is a bifacial contact solar cell, L1/d1≥131 and L2/d2≥262.

Exemplarily, when doping types of the doped semiconductor layer closest to the edge and the substrate are the same, d1=0mm. In fact, the doped semiconductor layer closest to the edge undergoes wet isolation, resulting in that d1 ranges from 10µm to 50µm in at least some regions. In the case of cutting half of a silicon wafer, d3 is the same as d1. In the case of cutting half of a solar cell, d3 ranges from 0.01mm to 0.595mm. Considering cutting accuracy, the lower limit value is used, and considering cutting damage, the upper limit value is used. In the case of cutting half of a solar cell, if d3 is excessively small, the solar cell is severely damaged after cutting. Therefore, d3 needs to be greater than 0, and distance increase improves a bifacial ratio. However, an excessively large distance reduces the power generation area or causes the displacement of the finger and the doped semiconductor layer to increase, thereby increasing electricity leakage risk. The above range is selected by comprehensively considering the bifacial ratio, the power generation area, cutting accuracy, and electricity leakage risk.

Exemplarily, when doping types of the doped semiconductor layer closest to the edge and the substrate are opposite, 0.01mm≤d1≤0.595mm and 0.01mm≤d3≤0.595mm. In fact, the doped semiconductor layer near the first side only undergoes laser isolation, while the doped semiconductor layer near the second side undergoes both laser isolation and laser cutting. Therefore, d3>d1, and a mechanism for selecting specific numerical ranges of d1 and d3 is the same as that for selecting the numerical range of d3 when the doping types of the doped semiconductor layer closest to the edge and the substrate are the same. Details are not described again.

In summary, 0mm≤d1≤0.595mm, 0.01mm≤d3≤0.595mm, and sizes suitable for large-scale production are: d1 or d3 ranges from 0.01mm to 0.2mm. The above range applies to both the back-contact solar cell and the bifacial contact solar cell. Similarly, the above range applies to both a half solar cell and an entire solar cell.

Exemplarily, when doping types of the doped semiconductor layer closest to the edge and the substrate are the same, d2=0mm. In fact, the doped semiconductor layer closest to the edge undergoes wet isolation, resulting in that d2 ranges from 10µm to 50µm in at least some regions.

Exemplarily, when doping types of the doped semiconductor layer closest to the edge and the substrate are opposite, 0.01mm≤d2≤0.595mm.

Exemplarily, when doping types of the doped semiconductor layer closest to the edge and the substrate on one side edge are the same, d2=0mm, and when doping types of the doped semiconductor layer closest to the edge and the substrate on the other side edge are opposite, 0.01mm ≤d2≤0.595mm. The one side edge and the other side edge include oppositely distributed partial edges extending along the first direction, that is, two opposite short sides set on the left and right in FIG 1. Certainly, through process optimization, d2 on both sides can also be set to the same value to adapt to different grid line layouts and component layouts. For example, if d2 on both sides is 0mm, both the doped semiconductor layer and the finger can be extended to the edge of the solar cell, increasing the effective power generation area of the doped semiconductor layer and improving the carrier collection efficiency in the edge of the solar cell.

In summary, 0mm≤d2≤0.595mm, and a size suitable for large-scale production is: d2 ranges from 0.01mm to 0.2mm. The above range applies to both the back-contact solar cell and the bifacial contact solar cell. Similarly, the above range applies to both a half solar cell and an entire solar cell.

It is found in the present application that for large-sized solar cells, d1 and d2 are particularly affected by L1 and L2. The large-sized solar cell herein refers to an entire solar cell with at least one side ≥ 156mm or a half solar cell with at least one side ≥ 78mm.

Exemplarily, the size of the entire solar cell is 156 * 156mm, and for a half solar cell, L1 is 156mm/2=78mm and L2=156mm. Based on the size of the solar cell, d1 is 0.01mm, 0.05mm, 0.1mm, 0.15mm, 0.2mm, 0.3mm, 0.45mm, or 0.595mm, and d2 is 0.01mm, 0.05mm, 0.1mm, 0.15mm, 0.2mm, 0.3mm, 0.45mm, or 0.595mm. Exemplarily, d1 is 0.595mm and d2 is 0.595mm. In this case, for the half solar cell, L1/d1 is 131 and L2/d2 is 262, that is, for a large-sized half solar cell, L1/d1≥131 and L2/d2≥262. For an entire solar cell, L1/d1 is 262 and the L2/d2 is 262, that is, for a large-sized entire solar cell, L1/d1≥262 and L2/d2≥262. This range theoretically applies to the bifacial contact solar cell and the back-contact solar cell.

However, in an actual solar cell design process, considering differences of the above characteristics between the bifacial contact solar cell and the back-contact solar cell, the bifacial contact solar cell can adopt the above ratio range, that is, for the half solar cell, L1/d1≥131 and L2/d2≥262, for the entire solar cell, L1/d1≥262 and L2/d2≥262. However, for the back-contact solar cell, d1 and d2 need to be reduced, the maximum value of d1 is 0.5mm, and the maximum value of d2 is 0.5mm. In this case, for a half solar cell, L1/d1 is 156 and L2/d2 is 312, that is, for a large-sized half back-contact solar cell, L1/d1≥156 and L2/d2≥312, for an entire solar cell, L1/d1 is 312 and L2/d2 is 312, that is, for a large-sized entire back-contact solar cell, L1/d1≥312 and L2/d2≥312.

Exemplarily, the size of the entire solar cell is 192.4 * 182.3mm, and for a half solar cell, L1 is 192.4mm/2=96.2mm and L2=182.3mm. Based on the size of the solar cell, when the solar cell is a back-contact solar cell, d1 is 0.01mm, 0.05mm, 0.1mm, 0.15mm, 0.2mm, 0.3mm, 0.45mm, or 0.5mm, and d2 is 0.01mm, 0.05mm, 0.1mm, 0.15mm, 0.2mm, 0.3mm, 0.45mm, or 0.5mm. A half solar cell is used as an example. Exemplarily, d1 is 0.01mm and d2 is 0.15mm. In this case, L1/d1 is 9620 and L2/d2 is 1215.3. Exemplarily, d1 is 0.2mm and d2 is 0.2mm. In this case, L1/d1 is 481 and L2/d2 is 911.5. Based on the size of the solar cell, when the solar cell is a bifacial contact solar cell, d1 is 0.01mm, 0.05mm, 0.1mm, 0.15mm, 0.2mm, 0.3mm, 0.45mm, or 0.595mm, and d2 is 0.01mm, 0.05mm, 0.1mm, 0.15mm, 0.2mm, 0.3mm, 0.45mm, or 0.595mm. Exemplarily, d1 is 0.01mm and d2 is 0.15mm. In this case, L1/d1 is 9620 and L2/d2 is 1215.3. Exemplarily, d1 is 0.2mm and d2 is 0.2mm. In this case, L1/d1 is 481 and L2/d2 is 911.5.

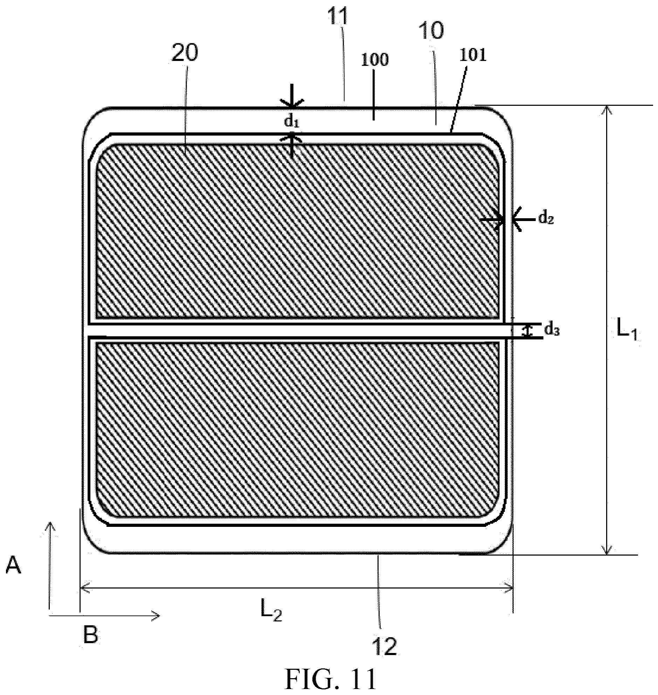

As shown in FIG. 11, an embodiment of the present application further discloses a solar cell, including two solar cells as described in the above embodiments. It can be understood that the solar cell in the above embodiment is the smallest unit of the solar cell, while the solar cell in this embodiment of present application includes two solar cells in the smallest unit mentioned above. The above ranges of d1, d2, and d3 of a half solar cell are also applicable to an entire solar cell.

It can be understood that in the solar cell disclosed in the embodiments of the present application, the width of the cell body along the first direction A is L1, and the length of the cell body along the second direction B is L2. A distance between the first side and the boundary of the doped semiconductor layer close to the first side is d1, and a distance between the boundary of the doped semiconductor layer near the edge of the cell body and the edge of the cell body along the second direction B is d2. When the solar cell is a large-sized entire back-contact solar cell, L1/2d1≥156 and L2/d2≥312; and/or when the solar cell is a large-sized entire bifacial contact solar cell, L1/2d1≥131 and L2/d2≥262.

An embodiment of the present application further discloses a photovoltaic module. The photovoltaic module includes a plurality of solar cells according to the foregoing embodiment, where the plurality of solar cells are spaced from each other.

It should be noted that, a structure of the solar cell included in the photovoltaic module in this embodiment of the present application is the same as that of the solar cell in the foregoing embodiment, and beneficial effects thereof are also similar. Details are not described herein again.

It should be noted that, the embodiments in this specification are all described in a progressive manner. Descriptions of each embodiment focus on differences from other embodiments, and same or similar parts among respective embodiments may be mutually referenced.

Although optional embodiments of the embodiments of the present application have been described, persons skilled in the art can make other changes and modifications to these embodiments once they know the basic creative concept. Therefore, the following claims are intended to cover the optional embodiments and all changes and modifications falling within the scope of the embodiments of the present application.

Finally, it should be further noted that, in the present application, relational terms herein such as first and second are used only to differentiate an entity from another entity, and do not require or imply any actual relationship or sequence between these entities. In addition, the terms "include", "comprise", and any other variants are intended to cover non-exclusive inclusion, so that an object or a terminal device that includes a series of elements not only includes such elements, but also includes other elements not expressly listed, or further includes elements inherent to the object or the terminal device. If no more limitations are made, an element limited by "include a/an..." does not exclude other same elements existing in the object or the terminal device which includes the element.

The technical solutions provided in the present application are described above in detail. Although the principles and implementations of the present application are described by using specific examples in this specification, persons of ordinary skill in the art may make modifications to the specific implementations and application range according to the principles and implementations of the present application. In conclusion, the content of this specification is not construed as limitation on the present application.

## Claims

1. A solar cell, comprising:
a cell body, wherein a width of the cell body is L₁ along a first direction, a patterned region being provided on a surface of the cell body; and
a plurality of fingers extending along a second direction, the plurality of fingers being arranged in the patterned region, wherein the plurality of fingers comprise a first finger and a second finger spaced from the first finger along the first direction, the second direction being different from the first direction; wherein
the cell body has a first side and a second side arranged opposite to the first side, each of the first side and the second side comprising portions extending along the second direction, a distance between the first side and a position of the patterned region close to the first side being D₁;
when the first finger and the second finger have opposite polarities, 80≤L₁/D₁≤400;
and/or when the first finger and the second finger have a same polarity, 50≤L₁/D₁≤350.

2. The solar cell according to claim 1, wherein the cell body comprises a substrate and a doped semiconductor layer formed on the substrate, the plurality of fingers being in electrical contact with the doped semiconductor layer, the first side and the second side being sides of the substrate, a distance between the first side and a boundary of the doped semiconductor layer close to the first side is d₁;
when the first finger and the second finger have opposite polarities, L₁/d₁≥156; and/or
when the first finger and the second finger have a same polarity, L₁/d₁≥131.

3. The solar cell according to claim 1, wherein when a plurality of first fingers and a plurality of second fingers have opposite polarities, a quantity of the plurality of first fingers or the plurality of second fingers is M, 0.9≤M/L₁≤1.8;
and/or when the plurality of first fingers and the plurality of second fingers have a same polarity, a sum of a quantity of the plurality of first fingers and a quantity of the plurality of second fingers is M, 0.9≤M/L₁≤1.8.

4. The solar cell according to claim 3, wherein when the plurality of first fingers and the plurality of second fingers have opposite polarities, 0.93≤M/L₁≤1.5;
and/or when the plurality of first fingers and the plurality of second fingers have a same polarity, 0.93≤M/L₁≤1.5.

5. The solar cell according to claim 1 or 3, wherein the cell body has two chamfers, two ends of the first side are directly connected to the two chamfers, respectively; and
a distance between the second side and a position of the patterned region close to the second side along the first direction is D₃, 0.5≤D3:D₁≤1.

6. The solar cell according to claim 1, wherein when the plurality of first fingers and the plurality of second fingers have opposite polarities, a distance between a respective first finger of the plurality of first fingers and a second finger adjacent to the respective first finger along the first direction is N, 11.00≤L₁/(D₁+N)≤37.02;
and/or N≤D₁≤2N.

7. The solar cell according to claim 6, wherein along the first direction, a distance between two adjacent first fingers closest to an edge or two adjacent second fingers closest to an edge is N₁, and a distance between two adjacent first fingers in the middle of the solar cell or second fingers in the middle of the solar cell is N₂, D₁<N₁<N₂, and/or 2D₁>N₁, or 2D₁>N₂, or 2N₁>N₂.

8. The solar cell according to claim 1, wherein a length of the cell body along the second direction is L₂, and a distance between a position of the patterned region close to an edge of the cell body and the edge of the cell body is D₂;
when the plurality of first fingers and the plurality of second fingers have opposite polarities, 150≤L₂/D₂≤750;
and/or when the plurality of first fingers and the plurality of second fingers have a same polarity, 50≤L₂/D₂≤650.

9. The solar cell according to claim 2, wherein a distance between a boundary of the doped semiconductor layer close to an edge of the cell body and the edge of the cell body along the second direction is d₂;
when the plurality of first fingers and the plurality of second fingers have opposite polarities, L₂/d₂≥312; and/or
when the plurality of first fingers and the plurality of second fingers have a same polarity, L₂/d₂≥262.

10. The solar cell according to claim 8, wherein D₁≥D₂.

11. The solar cell according to claim 8, wherein in a case that the cell body is a rectangle structure or a rectangle-like structure,
when the plurality of first fingers and the plurality of second fingers have opposite polarities, L₁/D₁≤L₂/D₂;
and/or when the plurality of first fingers and the plurality of second fingers have a same polarity, L₁/D₁≥L₂/D₂.

12. The solar cell according to claim 1, wherein 75 mm≤L₁≤175 mm;
and/or a length of the cell body along the second direction is L₂, 150 mm≤L₂≤350 mm; and/or an area of the cell body is S, 11250 mm²≤S≤61250 mm².

13. The solar cell according to claim 3, wherein 50≤M≤225.

14. A solar cell, comprising:
a cell body, wherein a width of the cell body is L₁ along a first direction, two patterned regions being defined on a surface of the cell body and spaced form each other along the first direction; and
a plurality of fingers extending along a second direction, wherein the plurality of fingers comprises a first finger and a second finger, the first finger and the second finger being spaced from each other along the first direction, the second direction being different from the first direction; wherein
the cell body has a first side and a second side arranged opposite to the first side , each of the first side and the second side comprising portions extending along the second direction, a distance between the first side and a position of the patterned region close to the first side and a distance between the second side and a position of the patterned region close to the second side being both D₁;
when the first finger and the second finger have opposite polarities, 80≤L₁/2D₁≤400;
and/or when the first finger and the second finger have a same polarity, 50≤L₁/2D₁≤350.

15. The solar cell according to claim 14, wherein when a plurality of first fingers and a plurality of second fingers have opposite polarities, a quantity of the plurality of first fingers or the plurality of second fingers is M, 0.9≤M/L₁≤1.8;
and/or when the plurality of first fingers and the plurality of second fingers have a same polarity, a sum of a quantity of the plurality of first fingers and a quantity of the plurality of second fingers is M, 0.9≤M/L₁≤1.8.

16. The solar cell according to claim 15, wherein when the plurality of first fingers and the plurality of second fingers have opposite polarities, 0.93≤M/L₁≤1.5;
and/or when the plurality of first fingers and the plurality of second fingers have a same polarity, 0.93≤M/L₁≤1.5.

17. The solar cell according to claim 14, wherein the cell body has four chamfers, two ends of the first side are directly connected to two of the four chamfers, respectively, and two ends of the second side are directly connected to the other two chamfers, respectively; and
a distance between the two patterned regions along the first direction is D₃, 0.5≤D₃:2D₁≤1.

18. The solar cell according to claim 17, wherein when the plurality of first fingers and the plurality of second fingers have opposite polarities, a distance between a respective first finger of the plurality of first fingers and a second finger adjacent to the respective first finger along the first direction in a same patterned region is N, 11.00≤L₁/2(D₁+N)≤37.02;
and/or N≤D₁≤2N.

19. The solar cell according to claim 18, wherein in a same patterned region, along the first direction, a distance between two adjacent first fingers closest to an edge or two adjacent second fingers closest to an edge is N₁, and a distance between two adjacent first fingers in the middle of the solar cell or two adjacent second fingers in the middle of the solar cell is N₂, D₁<N₁<N₂, and/or 2D₁>N₁, or 2D₁>N₂, or 2N₁>N₂.

20. The solar cell according to claim 14, wherein a length of the cell body along the second direction is L₂, and a distance between a position of the patterned region close to an edge of the cell body and the edge of the cell body is D₂;
when the plurality of first fingers and the plurality of second fingers have opposite polarities, 150≤L₂/D₂≤750;
and/or when the plurality of first fingers and the plurality of second fingers have a same polarity, 50≤L₂/D₂≤650.

21. The solar cell according to claim 20, wherein D₁≥D₂.

22. The solar cell according to claim 20, wherein in a case that the cell body is a rectangle structure or a rectangle-like structure,
when the plurality of first fingers and the plurality of second fingers have opposite polarities, L₁/2D₁≤L₂/D₂;
and/or when the plurality of first fingers and the plurality of second fingers have a same polarity, L₁/2D₁≥L₂/D₂.

23. The solar cell according to claim 14, wherein 75 mm≤L₁/2≤175 mm;
and/or a length of the cell body along the second direction is L₂, 150 mm≤L₂≤350 mm;
and/or an area of the cell body is S, 11250 mm²≤S/2≤61250 mm².

24. The solar cell according to claim 15, wherein 50≤M/2≤225.

25. A photovoltaic module, comprising a plurality of solar cells, wherein each of the plurality of solar cells being a solar cell according to any one of claims 1 to 24, the plurality of solar cells being spaced from each other.
